# EUROPEAN PATENT APPLICATION

(11) **EP 1 503 424 A2**
(43) Date of publication of application: **02.02.2005**
(21) Application number: 04447182.9
(22) Date of filing: 26.07.2004
(51) Int. Cl.: H01L 29/786, H01L 21/336

(54) **Multiple gate semiconductor device and method for forming same**

(30) Priority: 25.07.2003 US 492442 P; 25.09.2003 EP 03447237
(71) Applicant: Interuniversitair Micro-Elektronica Centrum (IMEC), 3001 Heverlee (BE)
(72) Inventor: Kottantharayil, Anil, 3000 Leuven (BE); Loo, Roger, 3010 Kessel-Lo (BE)
(74) Representative: Van Malderen, Joelle

(57) **Abstract**

In accordance with an embodiment of the invention, a FinFET device is disclosed which comprises a strained silicon channel layer formed on, at least, the sidewalls of a strain-relaxed silicon-germanium body.

## Description

### Field of the invention

The present invention is related to integrated circuits and methods for manufacturing such integrated circuits. More particularly the present invention relates to semiconductor devices with a double or triple gate comprising a strained channel layer. The present invention also relates to semiconductor device having a silicon-germanium fin.

### Background of the invention

Current state-of-the-art semiconductor chips feature technology with circuit feature sizes of 180 nanometers, with components manufactured with technologies having 130 nanometer feature sizes just beginning to reach the marketplace. Industry plans are to deliver 90 nanometer technologies in the year 2004, 65 nanometers in the year 2007, 45 nanometers in the year 2010, 32 nanometers in the year 2013 and 22 nanometers in the year 2016. This schedule was set forth in the International Technology Roadmap for Semiconductors (ITRS) defined by the Semiconductor Industry Association (SIA) in 2001. The schedule translates to smaller chip dimensions earlier in time than had been previously thought. Among the main transistor scaling issues to be solved is the need for thinner gate oxides that result in a higher on-current and hence increased switching speed in semiconductor devices, a smaller off-current and lower threshold voltage to allow such gate oxide scaling, and the use of lower supply voltages, a higher channel mobility and smaller series resistance of the source/drain regions. In order to meet these forecasted scaling requirements, non-classical CMOS (Complementary Metal-Oxide-Semiconductor) devices and novel materials, such as metal gate materials and high-k gate dielectrics are currently under investigation.

One type of such non-classical CMOS devices is multiple gate devices, including so-called FinFET devices. In a typical FinFET device, the gate at least partially envelops the channel region, contrary to the classic planar device where the gate electrode is formed in a single plane on top of the channel region, where the channel region is part of the substrate. In a FinFET transistor, a semiconductor fin connects the source and drain regions. The gate material straddles this fin and forms, at least at the sidewalls of the fin, a gate structure that results in vertical channels being defined between the source and drain, near the surface of the fin. The electrical width of a FinFET is therefore, in a first instance, determined by the height of the fin and, in a second instance, by the geometrical width of the fin. However, to improve the performance of such FinFET devices (e.g. increase the mobility of the carriers in the channels) additional measures are needed.

One approach that has been employed to improve carrier mobility for hole carriers in planar devices is the use of a channel layer that is formed by growing silicon-germanium on silicon. An example of such an approach is described in US Patent No. 6,475,869 (the '869 patent). In this regard, the '869 patent discloses a method for forming such a double gate transistor having an epitaxial silicon/germanium channel region. After forming a silicon fin having a desired width, a layer of silicon-germanium is provided on the sidewalls of the fin, and the top surface of the fin is covered with a capping layer. After forming this silicon-germanium layer, normal processing of the FinFET is continued. While such a device configuration improves the carrier mobility for hole carriers, techniques for improving the carrier mobility of both electron and hole carriers are desirable.

### Summary of the invention

In a first aspect of the invention a semiconductor device is disclosed comprising a substrate, a first contact region and a second contact region formed on this substrate, a semiconductor fin in between and connecting these first contact region and said second contact region; characterized in that the semiconductor fin comprises a strain-relaxed silicon-germanium core. This strain-relaxed silicon-germanium core has a surface not facing the substrate.

In an exemplary embodiment of the invention a semiconductor device comprises a substrate, a source and a drain region formed on said substrate, a semiconductor fin in-between and connecting said source region and said drain region, and a gate that straddles the semiconductor fin, where the semiconductor fin comprises, at least along its sidewalls, an layer in contact with the gate and a strain-relaxed silicon-germanium core in contact with this layer.

This layer in between the gate and the strain-relaxed silicon-germanium core may comprise an element selected from the group III atomic elements or the group V atomic elements. Alternatively, this layer may comprise silicon or germanium. This layer may be present along the sidewalls of and along the top surface of the semiconductor fin, or may be present along the sidewalls only.

In an alternative embodiment, a semiconductor device, according to this invention, comprises a substrate, a first contact region and a second contact region formed on the substrate, a semiconductor fin between and connecting the first said second contact regions, where the semiconductor fin comprises, at least along its sidewalls, an layer formed on a strain-relaxed silicon-germanium core. This layer may comprise at least one element selected from the group III or V atomic elements or, alternatively, may comprise silicon or germanium.

In a second aspect of the invention a method for manufacturing a semiconductor device according to embodiments of the first aspect is disclosed. This method comprises providing a substrate comprising a source, a drain and a fin between, and connecting said source and said drain. The fin is formed of a first semiconductor material. The method can further comprise depositing an alloy layer of a second and a third semiconductor material over at least the sidewalls of the fin and at least partially oxidizing the alloy layer to form an oxide of the second material and to form an alloy of the first and third semiconductor materials. The method can further include removing said oxide layer. In certain embodiments, the method can further comprise depositing a layer of a fourth semiconductor material over at least the sidewalls of the fin, where the first and said second semiconductor materials comprise silicon. The third semiconductor material may comprise germanium, while the fourth semiconductor material may also comprise silicon. The alloy layer of a second and third semiconductor material is selectively deposited on the exposed surfaces of the fin only. These exposed surfaces may be the sidewalls and the top surface of the fin or, alternatively, only the sidewalls of the fin. The alloy comprising the first and third semiconductor materials forms a strain-relaxed body.

### Description of figures.

The attached drawings are intended to illustrate some aspects and embodiments of the present invention. Devices are depicted in a simplified way for reason of clarity. Not all alternatives and options are shown and, therefore, the invention is not limited to the content of the drawings. In the drawings, like numerals are employed to reference like parts in the various figures, in which:

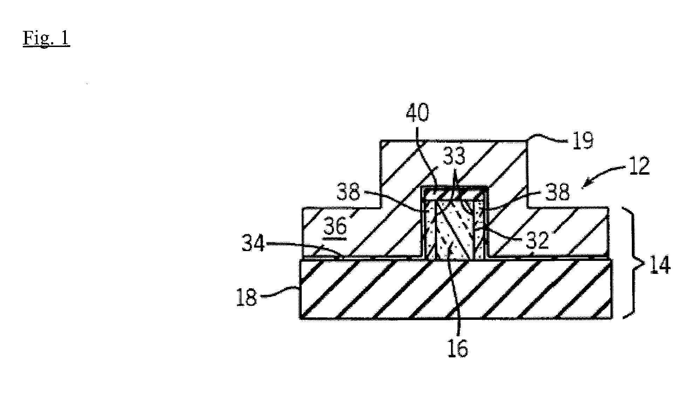

Figure 1 shows a cross-sectional view of a prior art FinFET device formed in an SOI layer as described in U.S. Patent No. 6,475,869, where a silicon-germanium layer is formed over the silicon fin.

Figure 2 shows an isometric view (a) of a FinFET device according to the present invention and a schematic cross section (b) A-A through the gate illustrating the strained silicon layer formed on the silicon-germanium body, (c) a fin device according to another embodiment of the invention, comprising a Si_{1-y}Ge_{y} body.

Figure 3 (a-e) shows a prior art process sequence of "Ge condensation", as disclosed in published U.S. Patent Application No. 2003/0006461 (Figure 8 of the application).

Figure 4 (a-e) shows a process sequence to manufacture a device according to an embodiment of the invention, as illustrated by schematic cross-sections (a) starting substrate, (b) forming the active area including fin formation, (c) epitaxial growth of SiGe, (d) thermal oxidation, (e) removal of oxide, deposition of Si.

Figure 5 shows a schematic cross section along line A-A (as in Figure 4) of a FinFET device according to an embodiment of the invention, wherein only the sidewalls of the fin are covered with a strained silicon layer.

### Detailed Description

In relation to the drawings, exemplary embodiments of the present invention are described in the following detailed description. However, it will be apparent to a person skilled in the art that numerous other equivalent embodiments or ways of practising the present invention exist.

In an exemplary embodiment of the invention, a strained channel FinFET device comprises at least two gates. A fin of the FinFET comprises a core of silicon-germanium and a strained silicon layer formed thereon. The FinFET further comprises a gate dielectric and a gate electrode layer overlying the strained silicon layer.

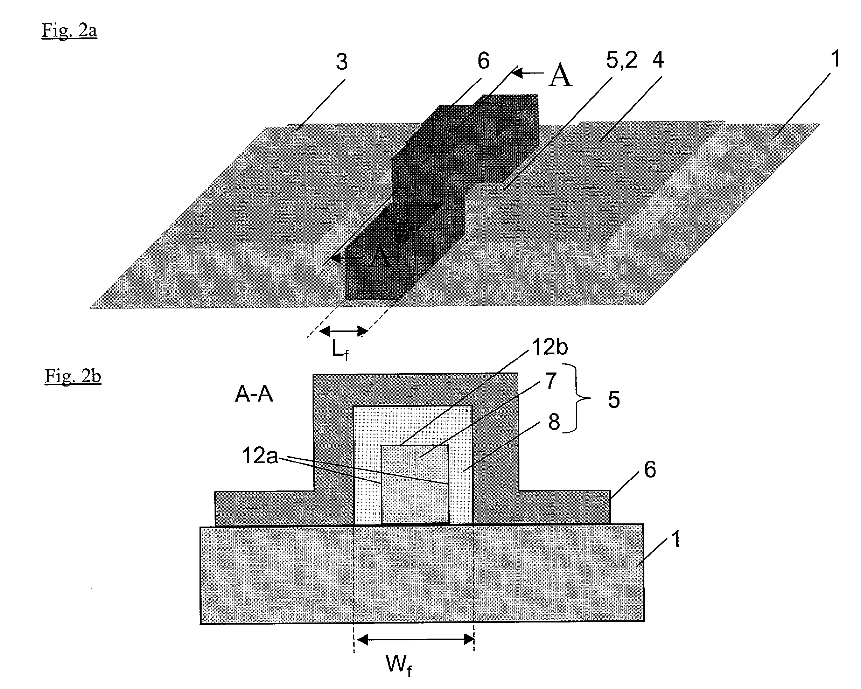

Referring now to Figure 2a, a FinFET device according to an embodiment of the invention is shown. In a semiconductor layer (2) present on a substrate (1) a FinFET device is formed. The substrate (1) may comprise a semiconductor substrate, e.g. silicon, germanium. Alternatively, the substrate may comprise an insulating layer formed on top of the substrate (1) to form, in combination with a semiconductor layer (2), a silicon-on-insulator (SOI) or a germanium-on-insulator (GeOI) substrate, as two examples. In certain embodiments, other semiconductor devices are formed in this semiconductor layer (2), which can be isolated using known isolation techniques such as trench, field oxide or mesa insulation.

The FinFET device comprises a source (3) and a drain (4), which are connected by a fin (5). Depending on the particular process flow used, the source (3), drain 4 and fin (5) can be formed in a single layer (2) of semiconductor material or, alternatively, in different layers of semiconductor material. A gate (6) comprising a gate dielectric and a gate electrode layer (both of which are not shown) is formed so as to overlay at least the fin (5) on three sides. The channel of the FinFET is, for this embodiment, the part of the fin (5), which is in contact with and hence, electrically influenced by the gate (6).

A cross-section along the gate (6) of the FinFET is shown in Figure 2b. Figure 2b illustrates that the gate 6 surrounds the surface (12) fin (5) which is not facing the substrate (1)., e.g., at both side surfaces (12a), as well on the top surface(12b). In embodiments that comprise a thick gate dielectric on top of the fin, a double gate device is obtained in which inversion occurs along the vertical sidewalls (12a) of the fin, i.e. those parts of the fin surface that are oblique to the substrate (1). For embodiments that comprise a thin gate dielectric, inversion may also occur in the top surface (12b) of the fin.

Also shown in the cross-section is the fin (5), which comprises, in this example, a silicon-germanium body or core (7) and a strained silicon layer (8) on the silicon-germanium body (7). In order to obtain a strained silicon layer with desirable characteristics, the underlying silicon-germanium body (7) has uniform lattice characteristics along these surfaces upon which the strained silicon (8) layer will be formed. At substantially every point along these surfaces, the composition of the lattice in a direction perpendicular to this surface will be substantially the same. In certain embodiments it is preferable that the lattice constant of the body (7) be substantially the same as the lattice constant of the bulk relaxed silicon-germanium layer having the same given germanium content. The semiconductor body (7) is thus a, preferably crystalline, strained relaxed layer.

The semiconductor body (7) has a geometrical width W_{f} and a channel length, i.e. the overlap of the gate (6) over the fin (5), L_{f} of 100 nm (nanometer) or less, 50nm or less, or 25nm or less. For embodiments where the strained relaxed core (7) is formed of an alloy of semiconductor materials, e.g. silicon alloyed with germanium, the content of the alloying element will depend on the particular embodiment. Over at least a part of the exposed surface of this strain relaxed core (7) a, preferably crystalline, strained layer (8) is formed. If the strained silicon layer (8) is to be formed on a strain-relaxed silicon-germanium core (7), then up to 50%, or up to 35% or upto 15% of germanium should present in the core. If a germanium layer (8) is formed on a strain-relaxed silicon-germanium core (7) then the core should preferably contain more than 60% germanium.

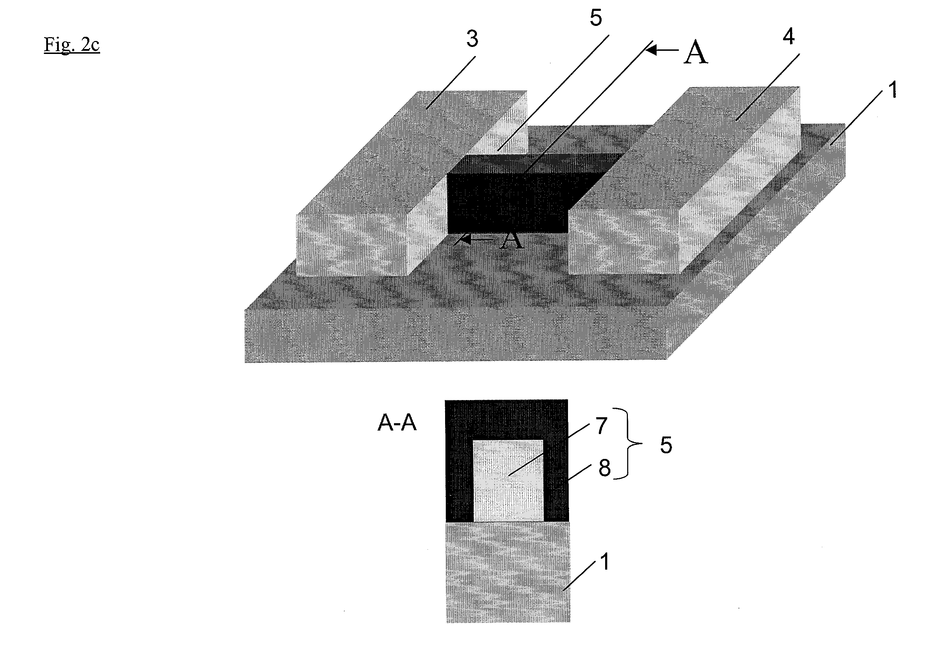

In a second exemplary embodiment, a semiconductor device comprises a first semiconductor contact region (3), a second semiconductor contact region (4) and a semiconductor fin (5) between and connecting the first and the second semiconductor region, as shown in figure 2c. This device is formed on a substrate (1). Typically the first and the second contact region are formed of the same semiconductor material, e.g. silicon. The body or core (7) of the semiconductor fin (5) is formed of silicon-germanium Si_{1-y}Ge_{y}, whereby 0 < y < 100%. Preferably, such silicon-germanium is crystalline and strain-relaxed. A semiconductor layer (8) may be grown on the exposed surfaces of this body (7). Depending on the lattice mismatch between this layer (8) and the body (7) compressive, tensile or no strain may be present in the layer (8). If a germanium layer (8) is grown on a silicon-germanium body (7), then the germanium layer (8) will be strained depending on the germanium content (e.g., the more germanium in the body (7) the less strain). On such a silicon-germanium body (7), other semiconductor layers may be formed. The semiconductor material of the layer (8) may be selected from the atomic elements of the group III-V of the periodic table, such as AlAs, GaAs, and AlGaAs. Such materials would then produce a small lattice mismatch with the underlying strain-relaxed silicon-germanium body (7). The latter combination of the layer (8) and the strain-relaxed body (7) would, inter alia, allow the formation of, and integration of, optoelectronic components in CMOS technologies, as such FinFET devices could be combined with optical devices.

An exemplary embodiment of a method for forming a strained channel FinFET device having at least two gates comprises forming the fin of the FinFET, where the fin comprises a body of silicon-germanium and a strained silicon layer covering at least the sidewalls of this body. The method further includes forming gate dielectric and gate electrode layers that overly the strained silicon layer. This method is illustrated by the schematic views shown in figure 4a-e.

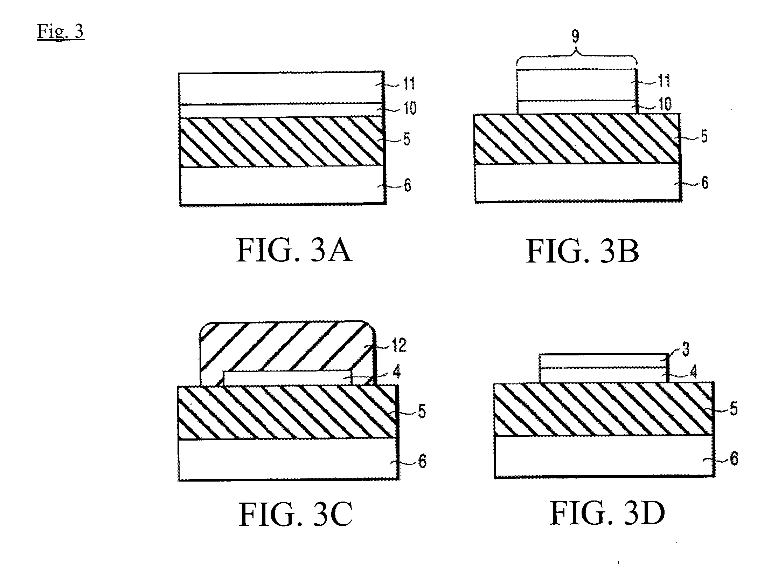

Published U.S. Patent Application No. 2003/006461 discloses a method for forming a planar CMOS device within a region of strain-relaxed silicon-germanium (SiₓGe_{y}). The content of U.S. Application No. 2003/006461 is hereby incorporated by reference in its entirety. On top of the region of strain-relaxed silicon-germanium, a strained silicon layer can be formed. The manufacturing of the strain-relaxed region, as illustrated by figures 3a-e, which corresponds to Figs. 8a-e of US 2003/006461. The process for forming such a device comprises the formation of a stack of a SiGe (11) and a Si (10) layer on an oxide layer (5). This stack of layers (10 and 11) is patterned to form an array of islands (9) of limited diameter, e.g. 5 micrometer. Then a dry oxidation process is performed to oxidize the exposed parts of the patterned SiGe layer. During this oxidation process, Ge atoms are expelled from the formed silicon oxide surface layer (12) into the remaining, i.e. unoxidized, SiGe layer (11). By interdiffusion of the piled-up Ge atoms and the Si atoms, also originating from the underlying patterned Si layer (10), the profile of the Ge in the resulting semiconductor layer (4) will be flat and is constant in a direction perpendicular to the substrate (6) on which the stack of SiGe on Si is formed. The formed silicon oxide layer (12) is removed, leaving only a lattice relaxed buffer layer (4) on which a strained silicon layer (3) is formed. This proposed method sequence, which is also known as the "germanium condensation technique" is only applied to planar structures. Finally as shown in figure 3e, the gate (1 and 2) of the planar device is formed on top of the strained silicon layer (3) while source/drain regions (7) are formed in each island (9), e.g. by ion implantation at opposite sides of this gate stack (1 and 2). US2003/006461 it directed to forming the total active area of the planar device to obtain a strain-relaxed buffer layer.

More generally the condensation technique can be described as forming an alloy layer of a second and third semiconductor material over a first semiconductor layer or structure. During oxidation, the atoms of the third semiconductor layer are expelled from this alloy and will form another alloy with the underlying first semiconductor layer, hence both semiconductors, first and third, must be miscible, while the solubility of the third semiconductor material with the oxide of the first semiconductor layer is low or negligible. The new alloy of the first and third semiconductor materials must yield a strain-relaxed layer, which may be accomplished by performing an annealing step. A layer of a fourth semiconductor material, having a lattice constant different from the lattice constant of the new alloy of first and third semiconductor material, is then formed over this alloy to yield a strained layer over the strain-relaxed layer. The first, second, third and fourth semiconductor layers may be selected from the atomic group of III, IV or V. The first, second, third and fourth semiconductor layers may be selected from the group of elements Si, Ge, and C. The fourth semiconductor layers may comprise GaAs, AlGa, AlGaAs.

A layer (8) of a fourth semiconductor material or an alloy thereof can be grown with or without strain on the new alloy. Depending on the mismatch between the lattice constant of this layer (8) and on the lattice constant of the new formed alloy (7) compressive, tensile or no strain may be present in this layer (8). If silicon is used to form the layer (8) and is grown over a silicon-germanium body (7), then the silicon layer (8) will be strained. If germanium is used to grow the layer (8) and is grown on a silicon-germanium body (7), then the germanium layer (8) will be strained depending on the germanium content (e.g., the more germanium in the body (7) the less strain). On such a silicon-germanium body (7), other types of semiconductor layers can be formed. The fourth semiconductor material may be selected from the atomic element of groups III-V of the periodic table, such as AlAs, GaAs, and AlGaAs. Such materials would have a small lattice mismatch with the underlying strain-relaxed silicon-germanium body (7). The latter combination of overlay layer (8) and strain-relaxed body (7) would, inter alia, allow the formation of, and integration of, optoelectronic components in CMOS technology, as FinFET devices may be combined with optical devices.

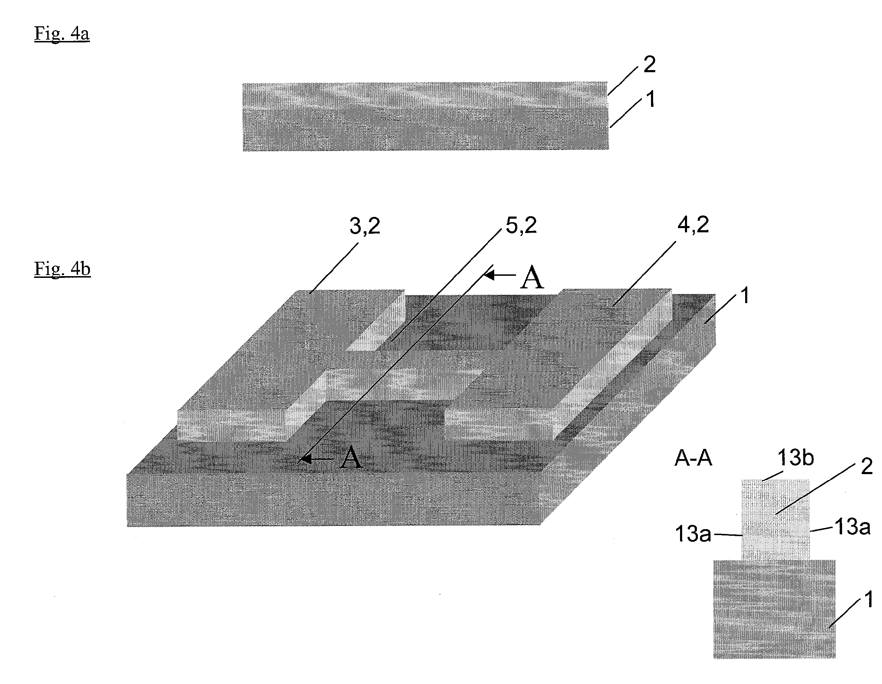

In another exemplary method, the "germanium condensation technique" is employed to form a FinFET device such that a strained relaxed semiconductor, e.g. SiGe, lattice is formed. The SiGe lattice would have substantially uniform characteristics on its exposed sides. Figures 4a-e illustrate by means of schematic drawings such a method. First, the starting material is provided, comprising a semiconductor layer (2) in which active areas, comprising source (3), drain (4) and fin (5) will be formed. The cross-section AA in figure 4b shows the surface (13) of the fin (5) which is not facing the substrate (1). In this example the fin (5) has a rectangular cross-section with sidewalls (13a) oblique to the substrate (1) and a top surface (13b) parallel to the substrate (1). The source, drain and fin may be formed in different layers of semiconductor material, which are patterned to abut each other. A person skilled in the art would know these alternative approaches to establish such regions. The semiconductor layer (2) is present on a substrate (1). The starting material may be a silicon-on-insulator substrate (SOI), comprising a silicon layer (2) supported by an oxide formed on a substrate. Alternatively, the starting material may be a semiconductor substrate (1) whereby one side of this substrate (1) is used as active layer (2). In the figures 4a-e only the top oxide layer of a SOI substrate will be shown and it is assumed that the source, drain and fin are formed within the same semiconductor layer (2). Patterning steps are performed to define in this semiconductor layer (2) source (3), drain (4) and a fin (5), which is located between and connects the source and drain regions. These patterning steps include the step of lithographic processing and etching. A characteristic of the FinFET device is that the width W_{g} of the fin is independent of the width of the source/drain regions. In comparison, for a planar device, the width of the transistor is defined by the width of the active area. In such devices the width of the channel region hence equals the width of the adjacent source and drain regions. In the case of a FinFET, however, the fin is smaller than the source (3) and the drain (4) regions and typically multiple fins are positioned in between both terminals (3 and 4). While the area of the latter two regions (3 and 4) can be made large enough, e.g. to allow the formation of contact holes on top of it, connecting the source/drain regions with interconnect levels above, the width of the fin can be selected to improve the channel performance. If the fin (5), the source (3) and the drain (4) are to be formed for example in the same semiconductor layer (2), the larger source (3) and drain (4) region can be defined in a photoresist layer during a first exposure step using e.g. optical lithography, while the smaller fin (5) can be defined in a photoresist layer during a second exposure step using an electron beam instead of 193 nm or 157 nm laser light as the smaller wavelength of e-beam allows the formation of very small lines. Both photoresist patterns may then be etched during the same dry etching step, which transfers the pattern in the underlying semiconductor layer (2). As already indicated, a FinFET constructed using such techniques may have a fin width W_{f} of 100nm or less.

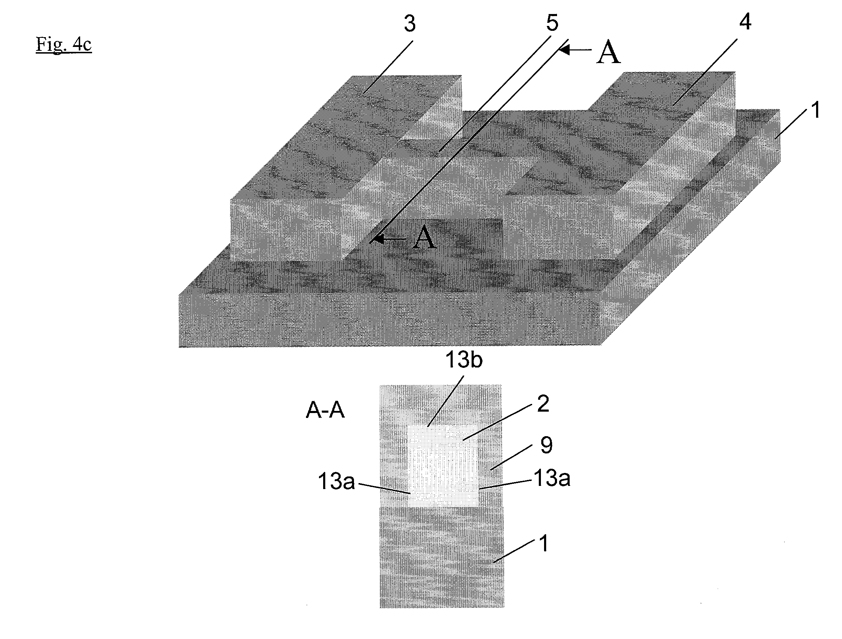

After patterning the source, drain and fin of each FinFET device, a uniform and conformal SiGe layer (9) is deposited. As shown in figure 4c, the layer (9) is formed selectively on the patterned semiconductor layer (2), while on the exposed parts of the substrate (1) no SiGe will be deposited. Such selective deposition may be obtained by using selective epitaxial growth. An alternative way to form a SiGe layer only on the source (3), drain (4) and fin (5), is to use selective atomic layer deposition (ALD). As shown in cross-section A-A the fin (5) has a rectangular cross-section with sidewalls (13a) oblique to the substrate (1) and a top surface (13b) parallel to the substrate (1). The surface (13) of the fin (5), which is not facing the substrate (1), is covered with the SiGe layer (9). Instead of using a selective deposition method, the substrate may be covered uniformly with a SiGe layer (9). In this case, the SiGe layer (9) covering the substrate surface between the FinFET must be removed in order to avoid short-circuiting the devices. As discussed below, the SiGe layer (9) may be removed by completely oxidizing this layer, thus forming an insulating layer between the FinFET devices.

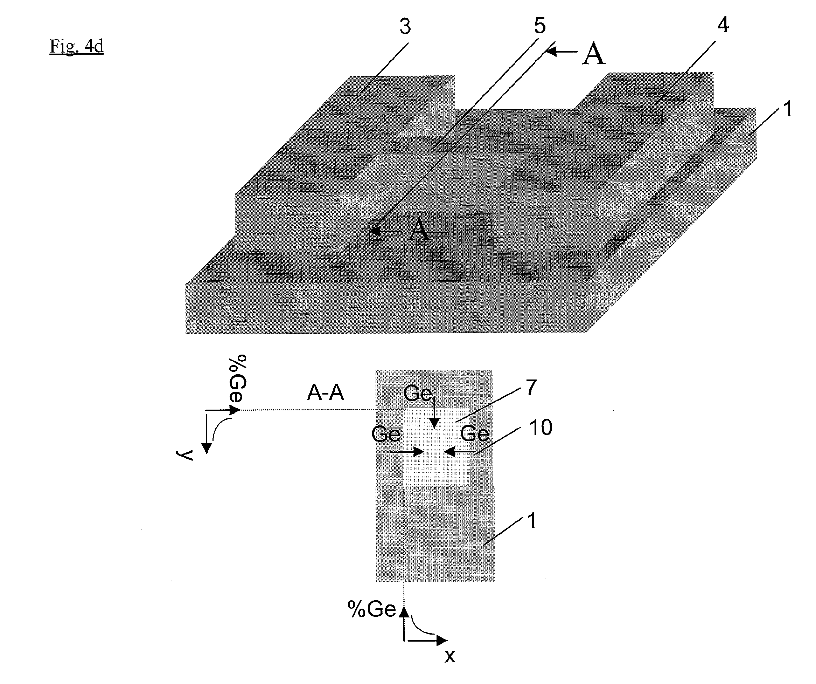

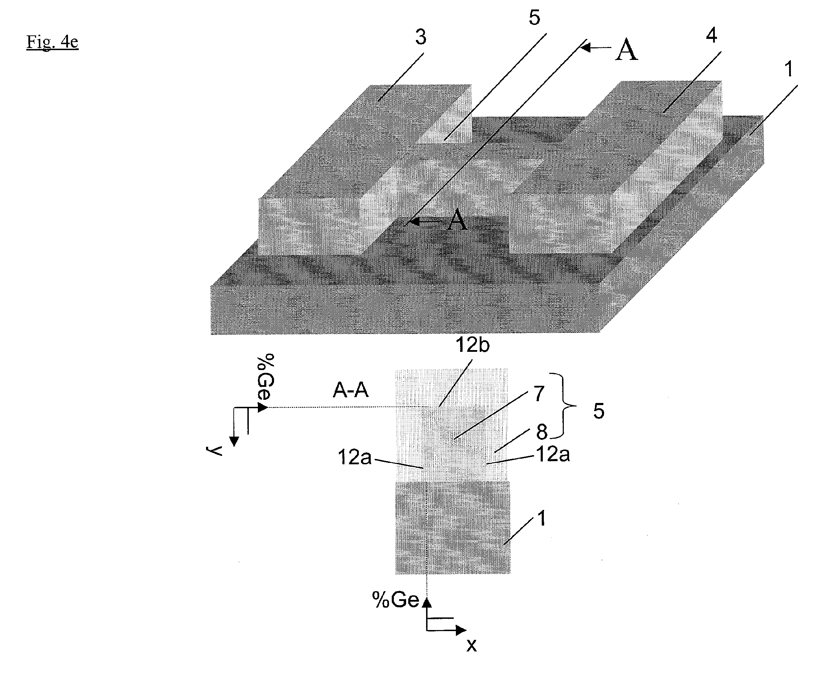

The substrate may be placed in an oxidizing atmosphere. The SiGe layer (9) will, as a result, be at least partially oxidized. A silicon-oxide layer (10) is then grown on top of the SiGe layer (9), which at least partially reduces the thickness of the SiGe layer (9). As a uniform SiGe layer (9) is formed, and as this layer is oxidized in an isotropic way, Ge atoms will diffuse from the outer surface of the SiGe (9) towards the center of the fin (5), as indicated in the cross-section at the bottom of figure 4d by the arrows labeled "Ge". This is schematically shown in figure 4d by a dopant profile in the horizontal direction (e.g., parallel to the substrate (1) and in vertical direction, and perpendicular to the substrate (1) indicating an initial pile-up of Ge atoms at the oxide (10) - SiGe (9) interface). At each point from the outer surface of the fin into the fin, substantially the same Ge profile will be obtained. By interdiffusion of the piled-up Ge atoms and the Si atoms, also originating from the underlying Si layer (2), the profile of the Ge in the resulting semiconductor layer (6) will be constant as is shown figure 4e by the dopant profiles in vertical and horizontal direction indicated at the cross-sectional view. The oxide layer (10) is removed by an etching step, e.g. a wet etch process using HF-based chemistry or a in-situ plasma cleaning performed in a deposition chamber, leaving the new SiGe layer (7) exposed. While the as-deposited silicon fin (2) is completely converted in a SiGe layer (7), source (3) and drain (4) regions will, due to their larger lateral dimensions, only be partially converted (e.g., the region near the exposed surfaces of source (2) and drain (3) is converted into SiGe leaving the composition of the center of source and drain as-deposited). Note that the exemplary method offers the advantage of subjecting the deposited SiGe layer to a limited number of processing steps, as SiGe is prone to oxidizing and wet processing steps. In case the conformal SiGe layer (9) is partially oxidized, some part of this layer (9) will remain in the final strained relaxed SiGe layer (7). Hence a crystalline SiGe layer (9) is to be formed, which is the case when using epitaxial layer growth. If, however, the conformal SiGe layer (9) is completely oxidized, the crystal structure of the as-deposited SiGe layer (9) is of little importance and other conformal deposition techniques can be used, e.g. chemical vapor deposition (CVD), such as non-selective epitaxial growth, which would yield a polycrystalline SiGe layer (9) on the oxide of the underlying substrate (1).

After the removal of the oxide (10) a strained silicon layer (8) is formed over the exposed SiGe layer (7). This strained silicon layer will encapsulate the underlying SiGe layer (7). As shown in cross-section A-A the fin (5) has a rectangular cross-section with sidewalls (12a) oblique to the substrate (1) and a top surface (12b) parallel to the substrate (1). The surface (12) of the fin (5), which is not facing the substrate (1), is covered with the silicon layer (8).

The processing of the FinFET may then be continued as is known in the art. On top of the strained silicon layer (7), the gate (6), comprising a gate dielectric and a gate electrode, is formed by depositing and patterning of dielectric and conductive layers. The source (3) and the drain (4) regions are implanted. This implant is also used to dope the gate, if a semiconductor material, such as polysilicon, is used as to form the gate electrode layer. Other process steps known to a person skilled in the art are then executed the complete the processing of the device, e.g. forming insulating layers covering the device, forming electrical contacts to contact the terminals (3, 4 and 6) of the device etc.

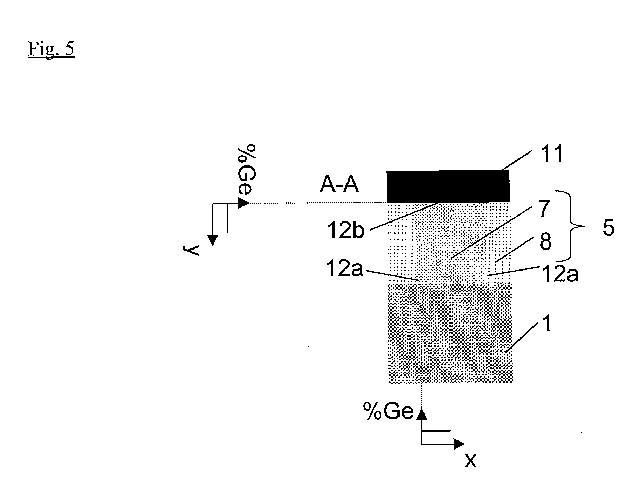

In an alternative embodiment, a capping layer (11) protects the top surface of the fin. This capping layer may be deposited uniformly over the active layer (2) and patterned together with the active layer (2) during the patterning of the fin. As this capping layer (11) adds to the thickness of the dielectric layer on top of the fin, a double gate FinFET is formed. The Ge of the as-deposited SiGe layer (9) will, during the oxidation step, only diffuse into the side surfaces of the underlying as-deposited silicon body (2), as the capping layer (11) acts as a diffusion barrier layer. A strained silicon layer is thus formed on the SiGe surfaces. The SiGe (9) and/or the strained silicon layer (8) may be formed in a uniform way, as discussed above. Figure 5 is a cross-section of a device according to this embodiment showing the device after the strained silicon layer (8) has been selectively formed on the SiGe core (7). As shown in cross-section A-A the fin (5) has a rectangular cross-section with sidewalls (12a) oblique to the substrate (1) and a top surface (12b) parallel to the substrate (1). Only the oblique parts (12a) surface (12) of the fin (5), which is not facing the substrate (1), is covered with the silicon layer (8).

## Claims

1. A semiconductor device comprising:
- a substrate (1) ;
- a first contact region (3) and a second contact region (4) formed on said substrate (1) ;
- a semiconductor fin (5) in between and connecting said first contact region (3) and said second contact region (4) ;
**characterized in that**
said semiconductor fin (5) having a body (7) consisting of a strain-relaxed material , said body (7) having a surface (12), said surface (12) not facing said substrate (1).

2. The semiconductor device of claim 1 wherein said strain-relaxed material is an Si_{1-y}Ge_{y} alloy with 0<y<1.

3. The semiconductor device of claim 1 or 2 further comprising a layer (8), said layer (8) at least partially overlaying said body (7), and said layer (8) being lattice mismatched with said underlying strain-relaxed body (7).

4. The semiconductor device of claim 3 wherein the semiconductor fin (5) further comprises a layer (8), which at least covers those parts (12a) of the surface (12) of said body (7), which are oblique to the substrate (1).

5. The semiconductor device of claim 3 wherein the layer (8) covers substantially the entire surface (12).

6. The semiconductor device of any of the foregoing claims further comprising a gate (6), which at least partially, straddles said semiconductor fin (5).

7. The semiconductor device of any of the foregoing wherein said first contact region (3) is a source region and said second contact region (4) is a drain region of a Field Effect Transistor.

8. The semiconductor device of claims 3, 4 or 5 wherein said layer (8) comprises one or more elements selected from the atomic groups III, IV or V.

9. The semiconductor device of claim 8, wherein one of said elements is germanium.

10. The semiconductor device of claim 8, wherein one of said elements is silicon.

11. The semiconductor device of claim 8, wherein said layer (8) comprises AlAs, GaAs or AlGaAs.

12. A method for manufacturing a semiconductor device having a fin, said fin comprising a strain-relaxed body, comprising:
providing a substrate (1), wherein the substrate comprises a source (3), a drain (4), and a fin (5) in between, and connecting, said source (3) and said drain (4), said fin (5) having a body (7) being formed of a first semiconductor material (2); said fin (5) having a surface (13) not facing said substrate (1),
depositing, at least on those parts (13a) of said surface (13) which are oblique to the substrate (1), an alloy layer (9) comprising a second and a third semiconductor material;
at least partially oxidizing said alloy layer (9) thereby forming an oxide (10) of said second material and thereby forming converting said body (7) of a first semiconductor material into an alloy of said first (2) and said third semiconductor materials, said alloy being a strain-relaxed material; and
removing said oxide (10) of said second semiconductor material.

13. The method of claim 12 further comprising the step of forming a layer (8) comprising a fourth semiconductor material, said layer (8) at least partially overlaying said body (7), and said layer (8) being lattice mismatched with said underlying strain-relaxed body (7).

14. The method of claim 13 wherein
said layer (8) at least covers those parts (12a) of the surface (12) which are oblique to the substrate (1).

15. The method of claim 12, 13, or 14 wherein said first and/or said second semiconductor materials comprise silicon.

16. The method of claim 12, 13, or 14 wherein said third semiconductor material comprises germanium.

17. The method of claim 12, 13, or 14 wherein said fourth semiconductor material is selected from the atomic groups III, IV or V.

18. The method of claim 17 wherein said fourth semiconductor material comprises silicon.
